# EUROPEAN PATENT SPECIFICATION

(11) **EP 0 390 542 B1**
(45) Date of publication and mention of the grant of the patent: **05.07.1995**
(21) Application number: 90303331.4
(22) Date of filing: 28.03.1990
(51) Int. Cl.: H01L 21/00

(54) **IC carrier**
Träger für integrierte Schaltungen
Support pour circuit intégré

(30) Priority: 30.03.1989 JP 79092/89
(43) Date of publication of application: 03.10.1990
(73) Proprietor: YAMAICHI ELECTRONICS CO., LTD., Ohta-ku, Tokyo (JP)
(72) Inventor: Matsuoka, Noriyuki, Tokyo (JP)
(74) Representative: Ben-Nathan, Laurence Albert

(56) References cited:
- GB-A- 1 326 437
- US-A- 4 435 724
- US-A- 4 547 794

## Description

### BACKGROUND OF THE INVENTION

### 1. Field of the Invention

This invention relates to an IC carrier used for carrying or measuring an IC package or in the like cases.

### 2. Brief Description of the Prior Art

A conventional one piece type of an IC carrier in which the whole IC carrier is integrally formed of a synthetic resin material comprises an IC package accommodating portion, and a plurality of retaining claws formed in a suitable place of the IC package accommodating portion. While previously forcefully displacing the retaining claws outward or forcefully displacing the retaining claws outward by a push-in force of the IC package, the IC package is loaded. By the restoring force of the retaining claws, the claws are brought into engagement with suitable places of the marginal area of the IC package. In this way, the IC package is carried by the IC carrier.

However the above-mentioned IC carrier has the following problems. In the conventional IC carrier, the retaining claws are engaged with and disengaged from the IC package by forcefully displacing the retaining claws. This usually requires a considerable amount of operation force in order to forcefully displace the retaining claws by a required amount. Moreover, careful attention must be paid to the handling of the retaining claws so as not to break the claws. Furthermore, in order to reduce the operation force, the retaining claws having an elastic portion must be made thin and thus the production becomes very difficult.

US-A-4,435,724 discloses a single piece carrier for IC devices comprising a square frame having engaging claws for holding an IC device. The frame is formed-with hinge portions to facilitate engagement and disengagement of the claws with the IC device.

### SUMMARY OF THE INVENTION

It is therefore an object of the present invention to provide an IC carrier capable of solving the above-mentioned problems.

The invention provides an IC carrier according to Claim 1.

The frame is bent or restored along one diagonal line by the hinge means at each end of that diagonal line of the frame in order to cause the engaging claws to be engaged with and disengaged from the IC package thereby to facilitate the loading and unloading of the IC.

The novel features of which are considered as characteristic for the present invention are set forth in particular in the appended claim. The invention itself, however, together with additional objects and advantages thereof, will be best understood from the following description of the specific embodiments when read in connection with the accompanying drawings.

### BRIEF DESCRIPTION OF THE DRAWINGS

Fig. 1 is a perspective view of an IC carrier showing a first embodiment of the present invention;
Fig. 2 is a plan view of the IC carrier;
Figs. 3 through 5 are sectional views taken along line A-A of Fig. 2 for explaining the process for loading an IC package, Fig. 3 is a normal state, Fig. 4 is a bent state of the IC carrier, and Fig. 5 is a state holding the IC package;
Fig. 6 is a perspective view of the IC carriage holding the IC package;
Fig. 7 is a perspective view of an IC carrier showing a second embodiment of the present invention;
Fig. 8 is a perspective view of the IC package loaded on the IC carrier;
Fig. 9 is a perspective view of an IC carrier showing a third embodiment of the present invention; and
Fig. 10 is a perspective view of the IC package loaded on the IC carrier.

### DETAILED DESCRIPTION OF THE EMBODIMENTS

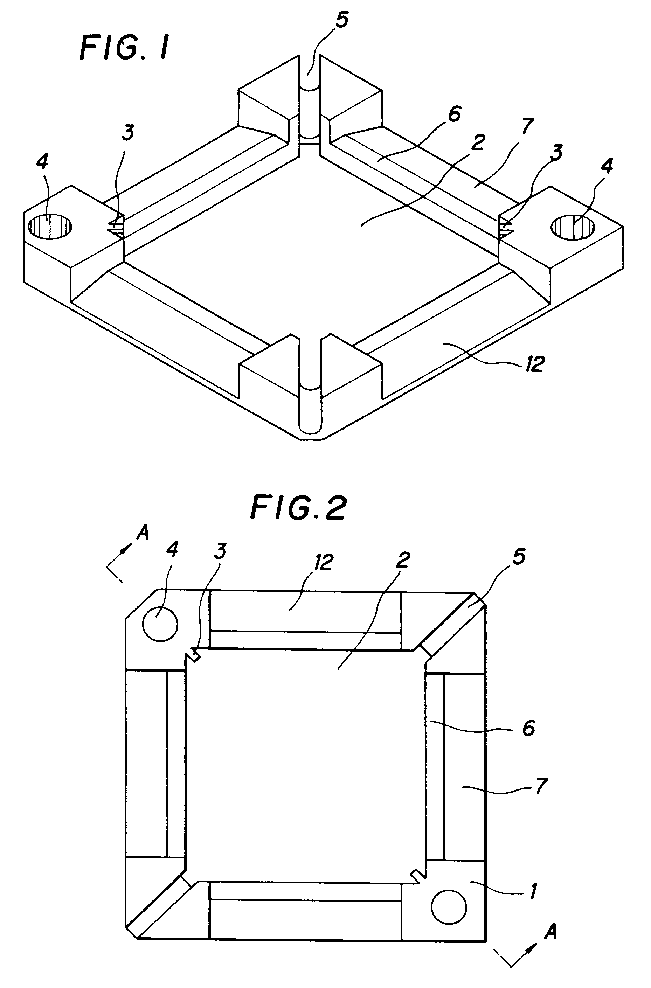

The embodiments of the present invention will now be described with reference to Figs. 1 through 8.

Fig. 1 is a perspective view of an IC carrier of the first embodiment of the present invention. The reference numeral 1 denotes an IC carrier body, which is formed of a square continuous frame 12. The IC carrier body 1 is provided in its central portion with an IC package accommodating portion 2 likewise formed in a square shape. The IC carrier body 1 is provided on its corner portion at each end of one of the diagonal lines with a hinge portion 5 through which the IC carrier body 1 can be bent against the resiliency, while a corner portion at each end of the other diagonal line is provided with an engaging claw 3 adapted to engage with a corner of the IC package body 1. Furthermore, the corner portion of the diagonal line with the engaging claw 3 formed thereon is a pressing force receiving portion 4 such as a hole having a bottom or the like which is located behind the engaging claw 3 and adapted to receive a pressing force when the IC carrier body 1 is bent.

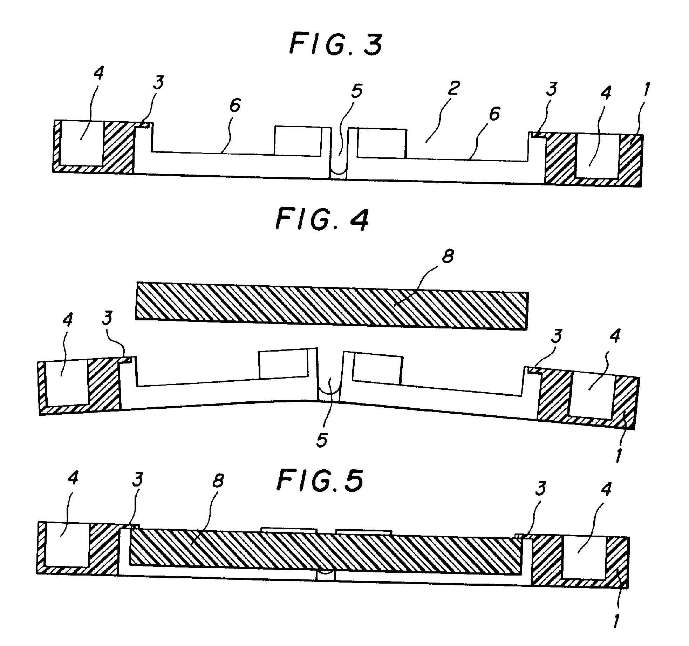

The hinge portion 5, as shown in Fig. 5, is provided with a groove formed in the corner portion of the carrier body 1 along the diagonal line and a thin portion having flexibility is integrally formed by the bottom wall of the groove so that the thin portion can serve as the hinge portion 5.

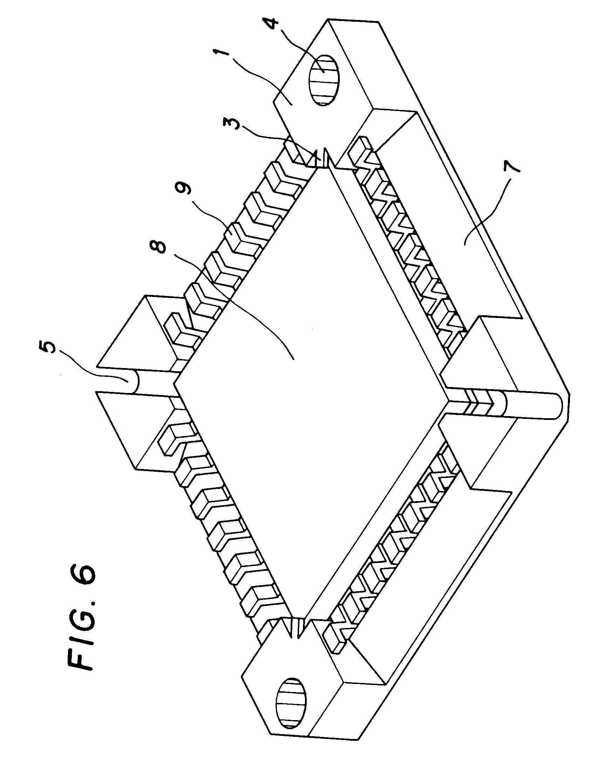

Also, the four sides of the frame 12 around the square IC package accommodating portion 2 are each provided with a contact piece supporting seat 6 adapted to support a contact piece 9 of the IC package 8. An outer surface on the outer edge of the contact piece supporting seat 6 has a contact (not shown) of a socket (not shown) interposed therein and is provided with a tapered portion 7 forming a contact space serving to contact the contact piece 9. That is, as is shown in Fig. 6, the contact piece 9 of the IC package 8 is supported by the outer surface on the inner edge side of the contact piece supporting seat 6, an upper end of the contact piece 9 being expanded upward exceeding the tapered portion 7 to form the contact space between the tapered portion 7 and the upper end of the contact piece 9. Fig. 2 is a plan view of Fig. 1.

Figs. 3 through 5 are sectional views taken on line A-A of Fig. 2 and are views showing the process for loading the IC package 8 of the IC carrier body 1. First, a pressing force is exerted to the pressing force receiving portion 4 as shown in Fig. 4 from a normal state shown in Fig. 3 to bend the IC carrier body 1 about the hinge portion 5 as a supporting point and separate apart the engaging claws 3 each other in order to make the distance longer than the length of the diagonal line of the IC package 8. In this state, when the IC package 8 is put into the IC package accommodating portion 2 and the pressing force is removed, the IC carrier is itself restored about the hinge portion 5 as shown in Figs. 5 and 6, and the engaging claws 3 separated apart are returned to the original position in order to engage with the angular portions of the IC package 8 so that the same can be held by the IC carrier body 1.

Next, in order to cancel the holding of the IC package 8, a pressing force is exerted again to the pressing force receiving portion 4 to bend it into a state as shown in Fig. 4 so that the engagement by the retaining claws 3 is cancelled to remove the IC package 8 or the IC carrier body 1 is inverted to allow it to drop out naturally by gravity.

Each of the retaining claws 3 is projected inward from the corner portion of the IC carrier body 1 along the diagonal line thereof. Also, the engaging claws 3 may be disposed on the extending portions of the opposite two sides of the frame.

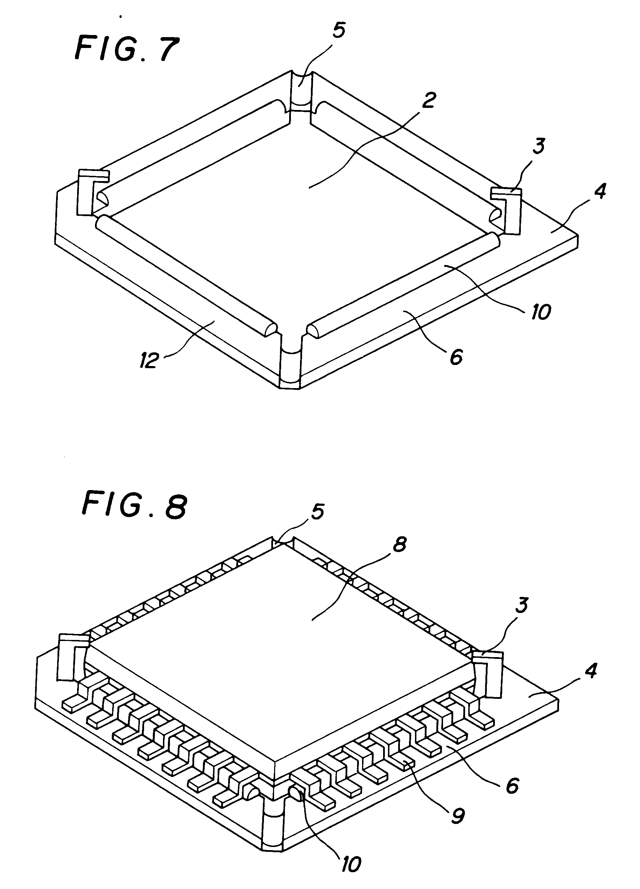

Fig. 7 is a perspective view of a second embodiment of the IC carrier of the present invention. Four sides of the frame 12 around the square IC package accommodating portion 2 formed in its center are provided with positioning projections 10 disposed along the outer surface of the frame and adapted to position both the four side edges of the IC package 8 and the bending portion of the contact piece 9 or either the four side edges or the bending portion. The IC carrier body 1 is provided with a hook-shaped engaging claw 3 erected from the corner portion of each end of one of the diagonal lines of the IC carrier body 1. The IC carrier body 1 is further provided with a flat pressing force receiving portion 4 formed behind the retaining claw 3 or in the vicinity of the corner portion. Fig. 8 is a perspective view showing a state where the IC package 8 is held by the IC carrier 1 of Fig. 7. The IC carrier body 1 is bent to accommodate the IC package 8 through the hinge 5 and restored to cause the engaging claw 3 to be engaged with the edge portion of the package 8. Also, the contact piece 9 of the IC package 8 is projected in such a manner as to be bent sideward and the inner side of the bending portion is supported on the projecting 10 so as to be positioned.

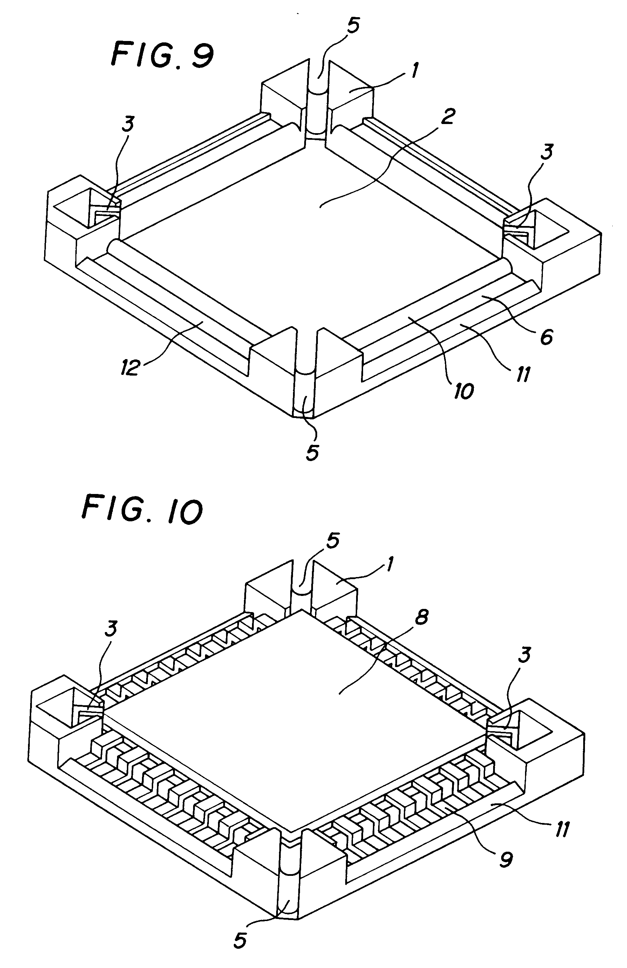

Fig. 9 is a perspective view of the IC carrier of the present invention. Four sides on the outer edge side of the frame 12 of the IC carrier body 1 of the second embodiment are provided with contact guide tapers 11 which are used as guides when the contacts of the socket are displaced.

Also, the corner portions on the diagonal lines are each provided with a hole and the retaining claw 3 is disposed within the hole in such a manner as that the tip of the engaging claw 3 is projected inward from the hole. Fig. 10 is a perspective view showing a state where the IC carrier 1 of Fig. 9 is bent and restored as previously stated so that the IC package 8 is held by the IC carrier 1.

In any of the above cases, breakage of the engaging claw as had in the conventional case where the engaging claw itself is forcefully displaced can be prevented, the opening and closing operation of the engaging claw becomes very easy, and the operation force is reduced. Furthermore, as the condition for making the retaining claw thin to increase resiliency is not accompanied, productivity by means of integral synthetic resin molding is also improved.

## Claims

1. An IC carrier including a frame (12) formed in such a manner as to be a square shape, an IC accommodating portion (2) formed in an internal area of said frame and adapted to accommodate an IC package (8) therein, a supporting portion (6) formed on said frame and adapted to support contact pieces of said IC package, and a pair of engaging claws (3) formed on said frame and adapted to hold said IC package, wherein opposite corner portions of said frame, at each end of one diagonal thereof, are formed with hinge means (5) adapted to enable parts of the frame to bend resiliently with respect to one another so as to facilitate engagement and disengagement of said claws (3) from said IC package, said claws (3) being disposed at respective corner portions of the frame (12) at each end of the other diagonal thereof, and said frame having at or in the vicinity of those respective corner portions pressing force receiving portions (4) receiving a pressing force when the frame is bent.

## Patentansprüche

1. IC-Träger, der folgendes enthält: einen Rahmen (12), der so ausgebildet ist, daß er rechteckiger Form ist, einen IC-Aufnahmeteil (2), der in einem inneren Bereich des Rahmes ausgebildet und so ausgeführt ist, daß er einen IC-Baustein (8) darin aufnehmen kann, einen Stützteil (6), der an dem Rahmen ausgebildet und so ausgeführt ist, daß er Kontaktstücke des IC-Bausteins stützen kann, und ein Paar Eingriffsklauen (3), die an dem Rahmen ausgebildet und so ausgeführt sind, daß sie den IC-Baustein festhalten, wobei einander gegenüberliegende Eckteile des Rahmens - an jedem Ende einer Diagonalen davon - mit Gelenkmitteln (5) ausgebildet sind, die so ausgeführt sind, daß sie es Teilen des Rahmens gestatten, sich im Verhältnis zueinander elastisch zu biegen, so daß die Ineingriffnahme und das Ausrücken der Klauen (3) mit dem bzw. von dem IC-Baustein erleichtert werden, wobei die Klauen (3) an jeweiligen Eckteilen des Rahmens (12) an jedem Ende der anderen Diagonalen davon angeordnet sind und der Rahmen an diesen jeweiligen Eckteilen oder in der Nähe davon Druckkraftaufnahmeteile (4) aufweist, die eine Druckkraft aufnehmen, wenn der Rahmen gebogen wird.

## Revendications

1. Socle de circuit intégré comportant un cadre (12) formé de manière à avoir une forme carrée, une portion de logement du CI (2) formée dans une zone interne dudit cadre et prévue pour y loger un boîtier de CI (8), une portion de support (6) formée sur ledit cadre et prévue pour supporter des pièces de contact dudit boîtier de CI, et une paire de mâchoires d'engagement (3) formées sur ledit cadre et prévues pour retenir ledit boîtier de CI, dans lequel des portions de coins opposés dudit cadre, à chaque extrémité d'une diagonale de ce dernier, sont formées avec des moyens de type charnière (5) prévus pour permettre à des parties du cadre de se plier élastiquement les unes par rapport aux autres, de manière à faciliter l'engagement et le désengagement desdites mâchoires (3) dudit boîtier de CI, lesdites mâchoires (3) étant disposées aux portions de coins opposés respectives du cadre (12) à chaque extrémité de l'autre diagonale de ce dernier, et ledit cadre ayant, à proximité de ou en ces portions de coin respectives, des portions (4) recevant une force de pression, qui reçoivent une force de pression lorsque le cadre est plié.
